# EUROPEAN PATENT APPLICATION

(11) **EP 4 120 073 A1**
(43) Date of publication of application: **18.01.2023**
(21) Application number: 21789428.6
(22) Date of filing: 09.04.2021
(51) Int. Cl.: G06F 9/445

(54) **CONFIGURATION METHOD FOR LOGICAL ADDRESS SPACE OF HARDWARE SINGLE BOARD, DEVICE, AND STORAGE MEDIUM**

(30) Priority: 13.04.2020 CN 202010284047
(71) Applicant: ZTE Corporation, Shenzhen, Guangdong 518057 (CN)
(72) Inventor: DONG, Chao, Shenzhen, Guangdong 518057 (CN)
(74) Representative: Osterhoff, Utz
(86) International application number: PCT/CN2021/086075
(87) International publication number: WO 2021/208805

(57) **Abstract**

Disclosed is a method for configuring a logical address space of a hardware board. The method includes: dividing the logical address space of the hardware board into N function blocks according to functions supported by the hardware board, N being a positive integer greater than 1, each function block corresponding to one function supported by the hardware board; and setting a function information area, a function implementation area and a function address area respectively in each function block, the function information area is configured to record information of the function block, the function implementation area is configured to realize the function of the function block, a function address area of n^{th} function block is configured to point to a start address of (n+1)^{th}function block, n is a natural number smaller than N, and a function address area of N^{th} function block is configured to point to a preset value.

## Description

### TECHNICAL FIELD

The embodiments of the present disclosure relate to the field of communications, and in particular, to a method for configuring a logical address space of a hardware board, a device, and a storage medium.

### BACKGROUND

Hardware description language (HDL) is a language for hardware behavior description, structure description and data flow description of electronic system. The design idea of digital circuit system can be described layer by layer from top to bottom (from abstract to concrete) through hardware description language, and a series of hierarchical modules can represent extremely complex digital circuit system.

Nowadays, hardware description language has been widely used in conventional hardware design. In a complete hardware and software system, hardware description language configures the logical address space of the hardware board, which is a link between the underlying hardware and the upper software.

However, the inventor found that in a hardware system composed of many different kinds of hardware boards, due to the difference between different types of hardware boards, the upper software needs to design codes for each type of hardware boards, resulting in poor compatibility of the hardware system.

### SUMMARY

The objective of the embodiments of the present disclosure is to provide a method for configuring a logical address space of a hardware board, a device, and a storage medium, such that the difference between different types of hardware boards in the hardware system reduces the impact on the code design of the upper software, which improves the compatibility of the hardware system.

In order to address the above technical problem, the embodiments of the present disclosure provide a method for configuring a logical address space of a hardware board, including: dividing the logical address space of the hardware board into N function blocks according to functions supported by the hardware board, N is a positive integer greater than 1, and each function block corresponds to one function supported by the hardware board; and setting a function information area, a function implementation area and a function address area respectively in each function block. The function information area is configured to record information of the function block, the function implementation area is configured to realize the function of the function block, a function address area of n^{th} function block is configured to point to a start address of (n+1)^{th} function block, n is a natural number smaller than N, and a function address area of N^{th} function block is configured to point to a preset value.

The embodiments of the present disclosure further provide a device, including: at least one processor; and a memory communicated with the at least one processor. The memory stores instructions executable by the at least one processor, when the instructions are executed by the at least one processor, the at least one processor executes the method for configuring the logical address space of the hardware board as described above.

The embodiments of the present disclosure further provide a computer-readable storage medium storing a computer program. When the computer program is executed by a processor, the method for configuring the logical address space of the hardware board as described above is implemented.

### BRIEF DESCRIPTION OF THE DRAWINGS

One or more embodiments are exemplified by the pictures in the corresponding drawings, and these exemplified descriptions do not constitute limitations on the embodiments.
FIG. 1 is a schematic flowchart of a method for configuring a logical address space of a hardware board according to a first embodiment of the present disclosure.
FIG. 2 is a schematic flowchart of a method for configuring a logical address space of a hardware board according to a second embodiment of the present disclosure.
FIG. 3 is a schematic diagram of dividing a logical address space of a hardware board according to a second embodiment of the present disclosure.
FIG. 4 is a schematic flowchart of a method for configuring a logical address space of a hardware board according to a third embodiment of the present disclosure.
FIG. 5 is a schematic diagram of dividing the logical address space of the hardware board according to a third embodiment of the present disclosure.

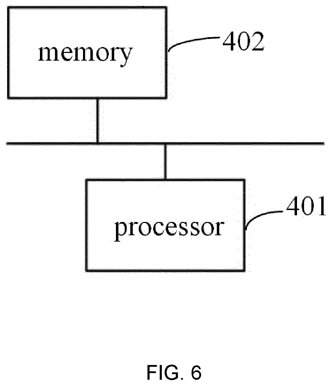

FIG. 6 is a schematic structural diagram of a device according to a fourth embodiment of the present disclosure.

### DETAILED DESCRIPTION OF THE EMBODIMENTS

In order to make the objectives, technical solutions and advantages of the embodiments of the present disclosure more clear, each embodiment of the present disclosure will be described in detail below with reference to the accompanying drawings. However, those of ordinary skill in the art can understand that, in each embodiment of the present disclosure, many technical details are provided for the reader to better understand the present disclosure. However, even without these technical details and various changes and modifications based on the following embodiments, the technical solutions claimed in the present disclosure can be realized.

A first embodiment of the present disclosure relates to a method for configuring a logical address space of a hardware board, including: dividing the logical address space of the hardware board into N function blocks according to functions supported by the hardware board, N is a positive integer greater than 1, and each function block corresponds to one function supported by the hardware board; and setting a function information area, a function implementation area and a function address area respectively in each function block. The function information area is configured to record information of the function block, the function implementation area is configured to realize the function of the function block, a function address area of n^{th} function block is configured to point to a start address of (n+1)^{th} function block, n is a natural number smaller than N, and a function address area of N^{th} function block is configured to point to a preset value. In this embodiment, the difference between different types of hardware boards in the hardware system reduces the impact on the code design of the upper software, which improves the compatibility of the hardware system. The implementation details of the method for configuring the logical address space of the hardware board in this embodiment will be specifically described below. The following contents are only implementation details provided for the convenience of understanding, and are not necessary to implement this solution.

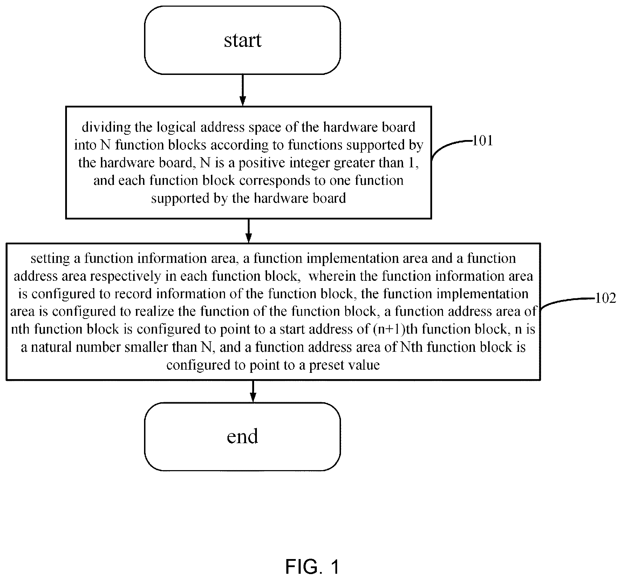

The method for configuring the logical address space of the hardware board in this embodiment is shown in FIG. 1.

Operation 101, dividing the logical address space of the hardware board into N function blocks according to functions supported by the hardware board. N is a positive integer greater than 1, and each function block corresponds to one function supported by the hardware board.

In some embodiments, the logical address space of the hardware board is divided according to the functions supported by the hardware board to obtain N function blocks. When dividing the function blocks, there is no specific requirement for the sequence relationship between the function blocks, and the address space range and the start address of each function block can be determined in combination with the total address space in the specific system.

Operation 102, setting a function information area, a function implementation area and a function address area respectively in each function block. The function information area is configured to record information of the function block, the function implementation area is configured to realize the function of the function block, a function address area of n^{th} function block is configured to point to a start address of (n+1)^{th} function block, n is a natural number smaller than N, and a function address area of N^{th} function block is configured to point to a preset value.

In some embodiments, the function information area is configured to record the information of the function block. The information of the function block may include the function block identification of the function block (the function block identification may be marked for each function block after step 101 is executed), the version number of the function block, the generation date of the function block, and the like.

It is worth mentioning that when the information of the function block recorded in each function information area includes the version number of the function block, in the subsequent management or maintenance of each function block, it is convenient to obtain the version number of each function block, which improves the maintainability of the hardware board.

The function implementation area is configured to realize the function of the function block. The function implementation area of each function block is a board support package (BSP) interface register that realizes the function of the function block, and is an interface for interacting with upper software.

The function address area is configured to point to the start address of another function block. The function address area of the N^{th} function block is configured to point to a preset value (or invalid address). A mapping relationship is established between the function blocks through the function address area pointing to the start address of the next function block, such that after loading a function block, the upper software can load the next function block according to the start address pointed to by the function address area of the function block, and when loaded into the function address area pointing to the agreed preset value (or invalid address), the loading of all function blocks is completed. For example, when N is equal to 3, the function address area of the first function block points to the start address of the second function block, the function address area of the second function block points to the start address of the third function block, and the function address area of the third function block points to the preset value (or invalid address).

In addition, in this embodiment, when setting the function information area, the information recorded in the function information area of each function block can be set uniformly. At this time, the space occupied by the function information area or the function address area of each function block is the same, which is beneficial to improve the loading efficiency of each function block by the upper software.

Compared with the related art, in this embodiment, the present disclosure provides a method for configuring a logical address space of a hardware board, including: dividing the logical address space of the hardware board into N function blocks according to functions supported by the hardware board, and each function block corresponds to one function supported by the hardware board; and setting a function information area, a function implementation area and a function address area respectively in each function block. The function information area is configured to record information of the function block, the function implementation area is configured to realize the function of the function block, a function address area of n^{th} function block is configured to point to a start address of (n+1)^{th} function block, n is a natural number smaller than N, and a function address area of N^{th} function block is configured to point to a preset value. The logical address space of the hardware board is divided into N function blocks according to the functions supported by the hardware board, so that the upper software can load the code for each function block without considering the type of each specific board. Besides, a mapping relationship is established between the function blocks through the function address area pointing to the start address of the next function block, such that after loading a function block, the upper software can load the next function block according to the address provided by the function address area of the function block, and finally complete the loading of all function blocks, thereby improving the compatibility of the hardware system.

A second embodiment of the present disclosure relates to a method for configuring a logical address space of a hardware board. The second embodiment is a further improvement of the first embodiment. The main improvement lies in that, in this embodiment, after the operation of dividing the logical address space of the hardware board into N function blocks according to the functions supported by the hardware board, the method further includes setting a reserved area in each function block.

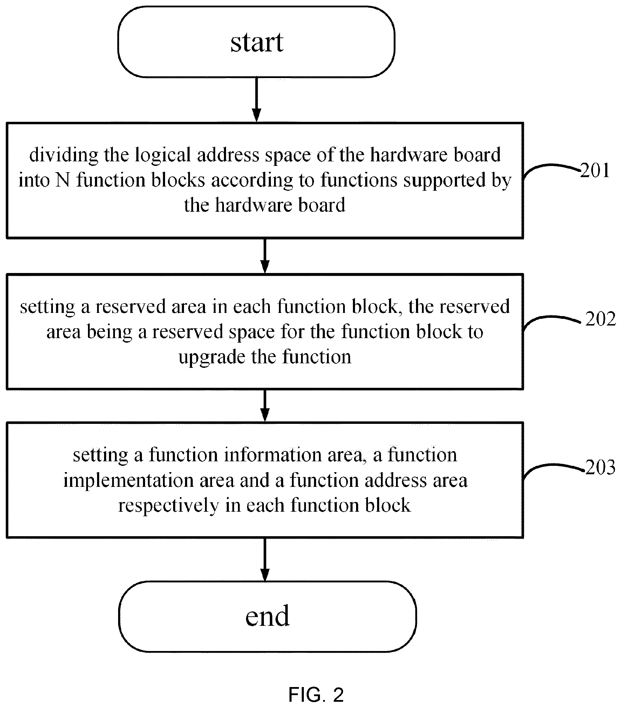

The method for configuring the logical address space of the hardware board in this embodiment is shown in FIG. 2. The method includes the following operations.

Operation 201, dividing the logical address space of the hardware board into N function blocks according to functions supported by the hardware board.

Operation 201 is substantially the same as operation 101 in the first embodiment, and to avoid repetition, details are not repeated herein.

Operation 202, setting a reserved area in each function block, the reserved area being a reserved space for the function block to upgrade the function.

In some embodiments, the reserved area is the reserved space for the function block to upgrade the function it supports. For example, the function of the board state information function block to record the reset reason of the board keeps records for 8 times. In the future, it may be necessary to increase the number of times to keep the reset reason records due to usage requirements. At this time, by setting the reserved area as the reserved space for the function block to upgrade the function, the space in the reserved area can be used to upgrade this function. Besides, when the interface control function block (for example, the Inter-Integrated Circuit (I2C) control function block supports the function of controlling the 12C interface) expands the number of interfaces, it can also expand the number of interfaces by using the space of the reserved area.

For example, in this embodiment, the size of the reserved area can be determined by the following methods. Before setting the reserved area in each function block, the size of the space occupied by each reserved area is determined according to the functions supported by the corresponding hardware board of each function block. When the size of the reserved area of the function block is determined, the size of the reserved area can be evaluated based on the maximum demand for upgrading the functions supported by the function block (refer to the function blocks of all boards that support the same function as the function block in the entire hardware system, and determine the size of the reserved area according to the application that occupies the largest space for the same function). A reserved area is set in each function block, and the size of the reserved area for each function block is determined according to the functions supported by the hardware board, such that in the subsequent function upgrade, the preset reserved area can meet the upgrade needs of each function block, and will not cause the problem of code compatibility before and after the upgrade.

For example, when the size of the reserved area of the board state information function block is determined, according to the function of "recording the reason for each reset of the board" supported by the function block, it takes 16 bits to record a reset reason. Currently, this function block supports 8 reset reason records. Considering in the board state information function block of all boards in the entire hardware system, for the function of "recording the reason for each reset of the board", the application that occupies the largest space is: if the record of 12 reset reasons is reserved, the size of the reserved area is determined to be 64bit ((12-8)*16). In another example, when the size of the reserved area of the 12C control function block is determined, the function block controls the 16 physical channels through the chip select register. Currently, the chip select register of this function block occupies 16 bits, and each bit corresponds to a physical channel. Considering that the maximum usage requirement of this function requires 32 physical channels, the size of the reserved area is determined to be 16 bits.

Operation 203, setting a function information area, a function implementation area and a function address area respectively in each function block.

Operation 203 is substantially the same as operation 102 in the first embodiment, and to avoid repetition, details are not repeated herein.

It should be noted that, in this embodiment, the operation of setting the reserved area in operation 202 and the operation of setting the function information area, the function implementation area and the function address area in operation 203 are not limited in order of precedence. In practical applications, operation 203 may also be performed first, and then operation 202 may be performed, or, operation 202 and operation 203 may be performed simultaneously.

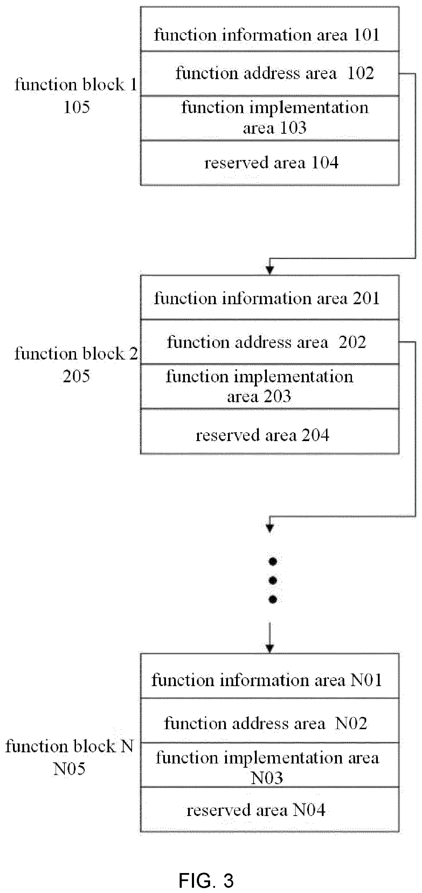

For example, FIG. 3 shows the division of the logical address space of the hardware board in the system. The label X05 (X=1, 2, ...... , N) is the logical address space based on a single independent function, and there are N in total. The logical address space of each independent function includes X01, X02, X03, and X04. X01 is the function information area, X02 is the function address area, X03 is the function implementation area, and X04 is the reserved area.

Compared with the previous embodiment, in this embodiment, after the operation of dividing the logical address space of the hardware board into N function blocks according to the functions supported by the hardware board, the method further includes setting a reserved area in each function block, the reserved area in each function block is a reserved space for the function block to upgrade the function.

A reserved area is configured in each function block as a reserved space for the function block to upgrade the function, so that each function block can use the reserved area to upgrade the function, and the hardware board has scalability.

A third embodiment of the present disclosure relates to a method for configuring a logical address space of a hardware board. The third embodiment is substantially the same as the second embodiment. The difference is that in this embodiment, in the operation of dividing the logical address space of the hardware board into N function blocks according to the functions supported by the hardware board, the N function blocks include a basic function block and a specific function block.

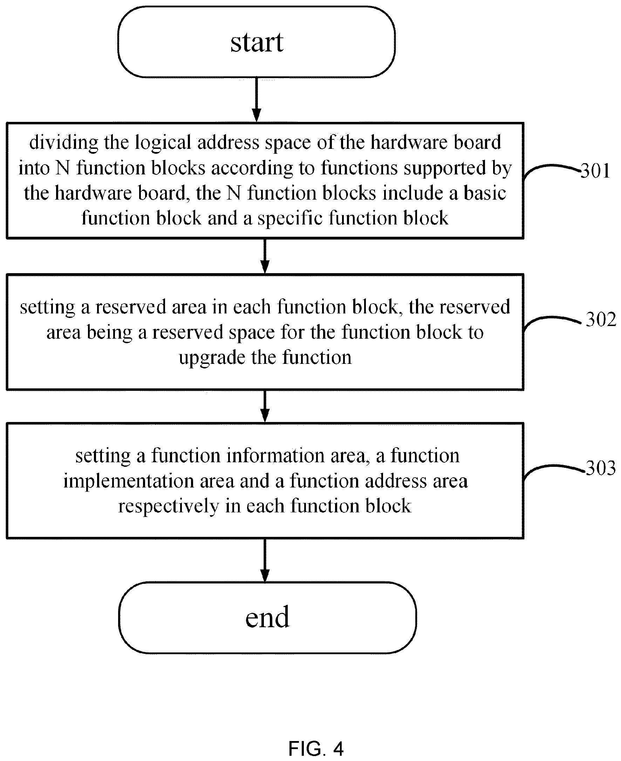

The method for configuring the logical address space of the hardware board in this embodiment is shown in FIG. 4. The method includes the following operations.

Operation 301, dividing the logical address space of the hardware board into N function blocks according to functions supported by the hardware board, the N function blocks include a basic function block and a specific function block.

In some embodiments, the logical address space of the hardware board is divided according to the functions supported by the hardware board to obtain N function blocks, and the N function blocks includes the basic function block and the specific function block. The basic function block is the basic function block common to all boards in the same hardware system. The set of logical function types to be implemented by all different hardware boards in the system is assumed to be A, then N<=A, and the value of N may be different for different hardware boards. Assuming that the number of basic function blocks shared by all hardware boards is B, then 1<=B<=A.

In this embodiment, the basic function block includes at least one of a logic device self-information function block, a board basic information function block, a board state information function block, or a board control register function block.

The specific function block includes at least one of an 12C controller function block, a Serial Management Interface (SMI)/Management Data Input/Output Interface (MDIO) controller function block, a Universal Asynchronous Receiver/Transmitter (UART) controller function block, a Serial Peripheral interface (SPI) controller function block, or a tooling test register function block.

Operation 302, setting a reserved area in each function block, the reserved area being a reserved space for the function block to upgrade the function.

Operation 303, setting a function information area, a function implementation area and a function address area respectively in each function block.

Operation 302 and operation 303 are substantially the same as operation 202 and operation 203 in the second embodiment, and to avoid repetition, details are not repeated herein.

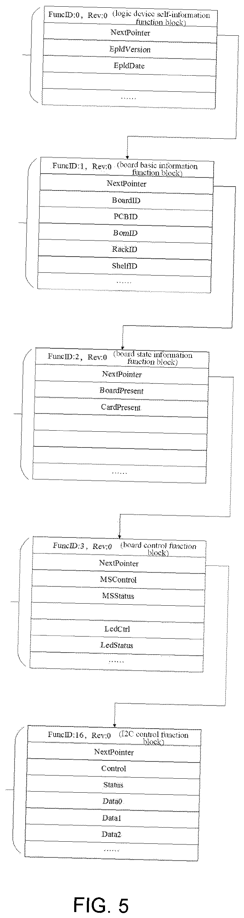

For example, FIG. 5 shows the division of the logical address space of the hardware board in the system. In this example, according to different types of boards, the logic functions of the boards are classified into 9 types, as shown in Table 1 (FuncID represents the function block identification of each function block), which are: logic device self-information, board basic information, board state information, board control register, 12C controller, SMI/MDIO controller, UART controller, SPI controller, tooling test register. The first four are basic functions shared by different boards. After the logical address space of the hardware board in FIG. 5 is divided, five function blocks are obtained, which are the logic device self-information function block (corresponding function: report programmable logic device self-information, version, generation date, or the like, the space length of the function block: 0x20), the board basic information function block (corresponding function: report the board basic information, such as BoardID, PCBID and other information, the space length of the function block: 0×40), the board state information function block (corresponding function: report board state information, such as sub-card presence information, or the like, the space length of the function block: 0×40), the board control function block (corresponding function: control the board, the space length of the function block: 0×40) and the I2C control function block (corresponding function: control the I2C interface, the space length of the function block: 0×40). The descriptions of English labels in FIG. 5 are described in Table 2.

**Table 1**

| Function block identification | Description |
|---|---|
| FuncID:0 | Logic device self-information |
| FuncID:1 | Board basic information |
| FuncID:2 | Board state information |
| FuncID:3 | Board control register |
| | |
| FuncID:16 | I2C controller |
| FuncID:17 | SMI/MDIO controller |
| FuncID:18 | UART controller |
| FuncID:19 | SPI controller |
| FuncID:20 | Tooling test register |

**Table 2**

| Item | Description |
|---|---|
| Register bit width | 16 bits |
| FuncID | Function block identification, 8 bits, range 0-255 |
| Revision | Version number, 8 bits, range 0-255 |
| NextPointer | Function address area, 32 bits |

In this embodiment, the address space of a single function block is divided, the logic device self-information function block is taken as an example. The function of this function block is to report the self-information, version, generation date, etc. of the programmable logic device. Its function block identification is 0, the space length of the entire function block is 0x20, and the register bit width is 16 bits. The function information area and the function address area are collectively called the logical function header. The function information area includes: FuncID (function block identification), which represents the function classification, 8bit, range 0-255; Revsion version number, which represents the function version, 8bit, range 0-255; Reserved for future function ID extension, 16bit. The function address area is represented as NextPointer, which represents the start address of the next function block, 32 bits, and the above part is called the logical function header because it is defined uniformly in different function modules and occupies the same bit width. The function implementation area in the logic device self-information function block includes EpIdVersion, which represents the current Epld logic version number, 16 bits. EpIdDate represents the compilation date of the current logical version, 16bit. The address space corresponding to the reserved area is the undefined area of 0xd-0x20, with a total of 160 bits, which is reserved for future function upgrades.

In this embodiment, the function address area of the logic device self-information function block points to the start address of the board basic information block. The board basic information function block then points to the board state information function block. The board state information function block points to the board control function block. The board control function block points to the I2C control function block. So far, the logic functions of the current hardware board have been listed. The interface area of the I2C controller points to the address 0xffff, which means that the current function module is the last function module of the board for software to determine.

Compared with the related art, in this embodiment, the method includes: dividing the logical address space of the hardware board into N function blocks, each function block corresponds to one function supported by the hardware board; setting a function information area, a function implementation area and a function address area respectively in each function block, the function information area is configured to record information of the function block, the function implementation area is configured to realize the function of the function block, a function address area of n^{th} function block is configured to point to a start address of (n+1)^{th}function block, n is a natural number smaller than N, and a function address area of N^{th} function block is configured to point to a preset value. The logical address space of the hardware board is divided into N function blocks according to the functions supported by the hardware board, so that the upper software can load the code for each function block without considering the type of each specific board. Besides, a mapping relationship is established between the function blocks through the function address area pointing to the start address of the next function block, such that after loading a function block, the upper software can load the next function block according to the address provided by the function address area of the function block, and finally complete the loading of all function blocks, thereby improving the compatibility of the hardware system.

The operations of the methods above are divided only for the purpose of describing clearly. Multiple operations can be combined into one operation or one operation can be divided into multiple operations, as long as they include the same logical relationship, and are all within the scope of this patent. Adding insignificant modifications to the algorithm or process or introducing insignificant designs without changing the core design of the algorithm and process are within the scope of this patent.

A fourth embodiment of the present disclosure relates to a device. As shown in FIG. 4, the device includes at least one processor 401 and a memory 402 communicated with the at least one processor 401. The memory 402 stores instructions executable by the at least one processor 401, when the instructions are executed by the at least one processor 401, the at least one processor 401 can perform the method for configuring the logical address space in any of the above method embodiments.

The memory 402 and the processor 401 are connected by a bus. The bus may include any number of interconnected buses and bridges that connect together the various circuits of one or more processors 401 and memory 402. The bus may also connect together various other circuits, such as peripherals, voltage regulators, and power management circuits, which are well known in the art and therefore will not be described further herein. The bus interface provides the interface between the bus and the transceiver. A transceiver may be a single element or multiple elements, such as multiple receivers and transmitters, providing a means for communicating with various other devices over a transmission medium. The data processed by the processor 401 is transmitted on the wireless medium through the antenna. In this embodiment, the antenna also receives the data and transmits the data to the processor 401.

The processor 401 is responsible for managing the bus and general processing, and may also provide various functions including timing, peripheral interface, voltage regulation, power management, and other control functions. The memory 402 may store data used by the processor 401 when performing operations.

Embodiments of the present disclosure further provide a computer-readable storage medium storing a computer program, and when the computer program is executed by a processor, the method for configuring a logical address space in any of the foregoing method embodiments is implemented.

That is, those skilled in the art can understand that all or part of the operations in the method of the above embodiments can be completed by instructing the relevant hardware through a program. The program is stored in a storage medium, and includes several instructions to cause a device (which may be a single-chip microcomputer, a chip, etc.) or a processor to execute all or part of the operations of the methods described in the various embodiments of the present disclosure. The aforementioned storage medium includes: U disk, removable hard disk, read-only memory (ROM), random access memory (RAM), magnetic disk or optical disk and other media that can store program codes.

Those of ordinary skill in the art can understand that the above-mentioned embodiments are specific embodiments for realizing the present disclosure. However, in practical application, various changes in form and details may be made therein without departing from the spirit and scope of the present disclosure.

## Claims

1. A method for configuring a logical address space of a hardware board, **characterized by** comprising:
dividing the logical address space of the hardware board into N function blocks according to functions supported by the hardware board, wherein N is a positive integer greater than 1, and each function block corresponds to one function supported by the hardware board; and
setting a function information area, a function implementation area and a function address area respectively in each function block, wherein the function information area is configured to record information of the function block, the function implementation area is configured to realize the function of the function block, a function address area of n^{th} function block is configured to point to a start address of (n+1)^{th} function block, n is a natural number smaller than N, and a function address area of N^{th} function block is configured to point to a preset value.

2. The method for configuring the logical address space of the hardware board according to claim 1, wherein after the dividing the logical address space of the hardware board into N function blocks according to functions supported by the hardware board, the method further comprises:
setting a reserved area in each function block, wherein the reserved area is a reserved space for the function block to upgrade the function.

3. The method for configuring the logical address space of the hardware board according to claim 2, wherein before the setting the reserved area in each function block, the method further comprises:
determining a size of a space occupied by the reserved area in each function block according to the function supported by the hardware board corresponding to each function block.

4. The method for configuring the logical address space of the hardware board according to claim 1, wherein the information of the function block recorded in each function information area comprises a version number of the function block.

5. The method for configuring the logical address space of the hardware board according to claim 1, wherein after the dividing the logical address space of the hardware board into N function blocks according to functions supported by the hardware board, the method further comprises:
marking a function block identification for each function block,
wherein the information of the function block recorded in each function information area comprises the function block identification of the function block.

6. The method for configuring the logical address space of the hardware board according to claim 1, wherein each function information area or each function address area occupies the same space.

7. The method for configuring the logical address space of the hardware board according to claim 1, wherein the N function blocks comprise a basic function block, and the basic function block comprises at least one of a logic device self-information function block, a board basic information function block, a board state information function block, or a board control register function block.

8. The method for configuring the logical address space of the hardware board according to claim 7, wherein the N function blocks further comprise a specific function block, and the specific function block comprises at least one of an I2C controller function block, an SMI/MDIO controller function block, a UART controller function block, an SPI controller function block, or a tooling test register function block.

9. A device, **characterized by** comprising:
at least one processor; and
a memory communicated with the at least one processor,
wherein the memory stores instructions executable by the at least one processor, when the instructions are executed by the at least one processor, the at least one processor executes the method for configuring the logical address space of the hardware board according to any one of claims 1 to 8.

10. A computer-readable storage medium storing a computer program, **characterized in that**, when the computer program is executed by a processor, the method for configuring the logical address space of the hardware board according to any one of claims 1 to 8 is implemented.
